# EUROPEAN PATENT APPLICATION

(11) **EP 4 722 742 A1**
(43) Date of publication of application: **08.04.2026**
(21) Application number: 25206471.2
(22) Date of filing: 02.10.2025
(51) Int. Cl.: G01R 31/00, G01R 31/28, G01R 31/3167, H04R 29/00, H04S 1/00

(54) **SYSTEM AND METHOD FOR MEASURING AN AUDIO PATH DELAY FOR AN AMPLIFIER BASED ON A CONTROL SIGNAL**

(30) Priority: 04.10.2024 US 202418907090
(71) Applicant: Harman Becker Automotive Systems, Inc., Novi, MI 48377 (US)
(72) Inventor: CHEN, Zhijun, Kawasaki, 215-0023 (JP)
(74) Representative: Rummler, Felix

(57) **Abstract**

In at least one embodiment, an audio system is provided. The audio system includes an audio controller and a measurement controller. The audio controller is programmed to transmit a control signal and an audio input signal. The amplifier is programmed to process the control signal and transmit the processed control signal on a control bus. The amplifier is further programmed to execute the processed control signal at at least one processor to perform an operation on the audio input signal. The measurement controller is programmed to determine a total time delay for performing the operation on the audio input signal at the amplifier. The total time delay corresponds to (i) a first-time delay associated with at least processing the control signal; (ii) a second time delay associated with at least transmitting the processed control signal; and (iii) a third time delay associated with at least executing the processed control signal.

## Description

### TECHNICAL FIELD

Aspects disclosed herein generally relate to a system and a method for measuring an audio path delay for an amplifier based on a control signal. This aspect and others will be discussed in more detail below.

### BACKGROUND

Audio systems generally include an electronic control unit ("ECU") (e.g., audio head unit or audio controller), an amplifier, and at least one loudspeaker. An audio interface is provided and positioned between the ECU and the amplifier to communicate (or provide) an audio input signal to the amplifier. In turn, the amplifier may amplify the audio input signal such that the loudspeaker transmits the amplified audio input signal into a listening environment. A data channel bus (or digital bus) may transmit the audio input signal from the ECU, digitally, to the amplifier at a rapid rate. In addition, control signals (or commands) may be transmitted on the digital bus. In this regard, the digital bus may be a control bus. However, the amplifier provides the amplified audio input signal to the loudspeaker in an analog format. It may be desirable to measure the amount of time that the amplifier processes the audio input signal relative to when the loudspeaker plays back the amplified audio signal in the listening environment. In another example, it may be desirable to measure the amount of time that the amplifier processes the control signals (or the commands) to execute a desired operation. In some cases, these may be difficult to perform.

### SUMMARY

In at least one embodiment, an audio system is provided. The audio system includes an audio controller and a measurement controller. The audio controller is programmed to transmit a control signal and an audio input signal. The amplifier includes at least one processor. The amplifier is programmed to process the control signal and transmit the processed control signal on a control bus. The amplifier is further programmed to execute the processed control signal at the at least one processor to perform an operation on the audio input signal. The measurement controller is programmed to determine a total time delay for performing the operation on the audio input signal at the amplifier. The total time delay corresponds to (i) a first-time delay associated with at least processing the control signal; (ii) a second time delay associated with at least transmitting the processed control signal; and (iii) a third time delay associated with at least executing the processed control signal at the at least one processor.

In at least one embodiment, a method for measuring a delay in an audio system is provided. The method includes receiving, at an amplifier, a control signal and an audio input signal and processing, at the amplifier, the control signal. The method includes transmitting the processed control signal on a control bus and executing the processed control signal at a processor of the amplifier to perform an operation on the audio input signal. The method further includes determining a total time delay for performing the operation on the audio input signal at the amplifier. The total time delay corresponds to (i) a first-time delay associated with at least processing the control signal; (ii) a second-time delay associated with at least transmitting the processed control signal; and (iii) a third-time delay associated with at least executing the processed control signal at the processor.

In at least one embodiment, a computer-program product embodied in a non-transitory computer readable medium stored in memory that is programmed and executable by at least one controller in an audio system. The computer-program product includes instructions to receive, at an amplifier, a control signal and an audio input signal and to process, at the amplifier, the control signal. The computer-program product includes instructions to transmit the processed control signal on a control bus and to execute the processed control signal at a processor of the amplifier to perform an operation on the audio input signal. The computer-program product includes instructions to determine a total time delay for performing the operation on the audio input signal at the amplifier. The total time delay corresponds to (i) a first-time delay associated with at least processing the control signal; (ii) a second-time delay associated with at least transmitting the processed control signal; and (iii) a third-time delay associated with at least executing the processed control signal at the processor.

### BRIEF DESCRIPTION OF THE DRAWINGS

The embodiments of the present disclosure are pointed out with particularity in the appended claims. However, other features of the various embodiments will become more apparent and will be best understood by referring to the following detailed description in conjunction with the accompany drawings in which:
FIGURE 1 generally illustrates one example of an audio system;
FIGURE 2 generally illustrates a more detailed implementation with test equipment for measuring a delay of an amplifier of the audio system of FIGURE 1;
FIGURE 3 generally illustrates a system for measuring an audio path delay in accordance with one embodiment; and
FIGURE 4 generally illustrates a more detailed view of the system of FIGURE 3 in accordance with one embodiment.

### DETAILED DESCRIPTION

As required, detailed embodiments of the present invention are disclosed herein; however, it is to be understood that the disclosed embodiments are merely exemplary of the invention that may be embodied in various and alternative forms. The figures are not necessarily to scale; some features may be exaggerated or minimized to show details of particular components. Therefore, specific structural and functional details disclosed herein are not to be interpreted as limiting, but merely as a representative basis for teaching one skilled in the art to variously employ the present invention.

It should be understood that the following description of embodiments is provided for illustrative purposes only and not for limiting purposes. The division of examples in functional blocks, controllers, units or other devices shown in the drawings should not be interpreted as indicating that these functional blocks, controllers, units, or other devices must be realized as physically separate units. It is recognized that these functional blocks, controllers, units, or other devices shown or described may be combined or separate in any manner. It is also recognized that that the functional blocks, controllers, units, or other devices may be implemented as circuits, electronic chips, or circuit elements. One or a plurality of the blocks illustrated in the figures may also be implemented in a common circuit, chip, circuit element, or unit.

The use of a singular term (such as, but not limited to, "a") is not intended to limit the quantity of the item. Use of relational terms such as, but not limited to, "top," "bottom," "left," "right," "upper," "lower," "downward," "upward," "lateral," "first," "second," ("third," and the like), "inlet," "outlet," and the like are used in written descriptions for clarity when specific reference is made to the drawings and are not intended to limit the scope of the present disclosure or the appended claims, unless otherwise specified. The terms "including" and "such as" are illustrative rather than restrictive, and the word "can" entails "can, but not necessarily," unless otherwise stated. Notwithstanding the use of any other language in the present disclosure, the embodiments shown in the accompanying drawings are examples given for purposes of illustration and explanation, and not the only embodiment of the subject matter herein.

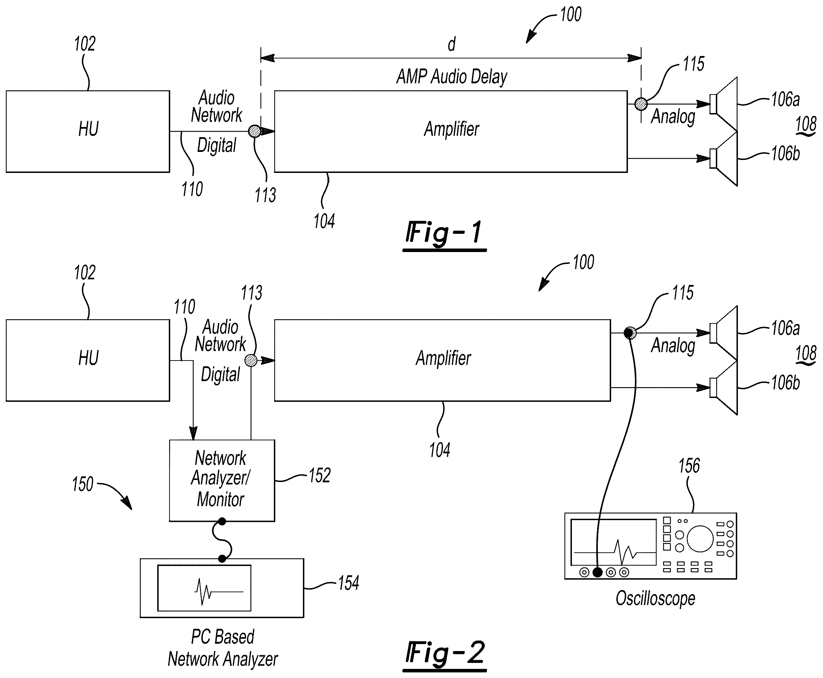

FIGURE 1 generally illustrates one example of an audio system 100. The system 100 generally includes a head unit (HU) 102 (e.g., audio controller 102), an amplifier 104, and a plurality of loudspeakers 106a - 106b (or "106"). In general, the audio controller 102 transmits an audio input signal to the amplifier 104. In turn, the amplifier 104 processes the audio input signal and transmits an amplified audio output signal to the loudspeakers 106 to playback the input audio signal in a listening environment 108. In one example, the loudspeakers 106 may be configured to play back the input audio signal in a cabin of a vehicle (not shown). It is recognized that the audio system 100 may be utilized for vehicle applications, home theatre applications, etc.

A digital communication bus 110 (or control bus 110) is positioned between the audio controller 102 and the amplifier 104. Thus, in this regard the audio controller 102 transmits the audio input channel digitally (e.g., audio input signal 111) on the control bus 110 to the amplifier 104. In addition, the audio controller 102 may transmit one or more control signals (or commands) over the control bus 110. The amplifier 104 processes and amplifies the audio input signal 111 to generate a processed and amplified audio input signal. The amplifier 104 transmits the processed and amplified audio input signal as an analog signal to the loudspeaker 106 for playback. Similarly, the amplifier 104 processes the control signals (or commands) as received from the head unit 102 via the control bus 110 to perform various operations. Various examples of operations will be noted below. It is generally desirable to ascertain the manner in terms of the amount of time (e.g., delay d) it takes for the amplifier 104 to process the control signals to perform the requested operation(s) .

Automotive Original Equipment Manufacturers (OEM) may require that audio providers provide measurement information in terms of delays attributed to the amplifier 104 in a vehicle. For example, an OEM may require that an amplifier 104 execute one command (or control signal) that corresponds to muting/umuting an audio input signal in *t1* ms. In another example, the OEM may require that the amplifier 104 execute another command (or control signal) that corresponds to the amplifier 104 generating an audio output signal (e.g., generate a wave) in *t2* ms. In another example, the OEM may require that the amplifier 104 execute another command (or control signal) that corresponds to outputting the audio output signal at a special sound sequency in *t3* ms. The special sound output sequency may correspond to a user command that commands the amplifier 104 to output a predetermined sequency of audio output. In one example, the predetermined sequency may correspond to an audio output signal that provides a 300 ms beep, followed by a 200ms mute, and then stopping to transmit the audio output signal. In another example, the predetermined sequency may correspond to an audio output signal that provides a first wave of audio output, which is followed by muting the first wave of the audio output for a time duration of 100ms, then providing a second wave of the audio output which is following by muting the second wave of an audio output for a time duration of 200ms and then repeating the playback and muting operation noted above. In another example, the OEM may require that the amplifier 104 execute another command (or control signal) that corresponds to stopping or ceasing to output the audio output signal in *t4* ms and to start outputting the audio output signal in *t5* ms. Thus, in light of these requirements, OEMs may require that audio providers establish that one or more of the commands noted above are executed within the time duration noted above. Therefore, as noted above, it is desirable to ascertain the manner the amount of time (e.g., delay d) for the amplifier 104 to process and execute the, at least the noted commands.

It is recognized that the commands are not limited to those noted above and that such commands may be associated to any number of operations performed by the amplifier 104. However, there are challenges in terms of obtaining the delay attributed to the amplifier 104 given that the received control signal is transmitted digitally from the audio controller 102 to the amplifier 104 and further that the detected output from the amplifier 104 is in an analog domain. In one implementation, there may be at least two measurement points 113, 115 in the system 100. In this case, a monitor may be electrically coupled to the system 100 at the measurement point 113 and an oscilloscope 156 (see FIGURE 2) may be operably coupled to the system 100 at the measurement point 115. Thus, in this regard, it is possible to monitor or measure the time in which the command is provided to the amplifier 104 at the measurement point 113 which may be provided over the control bus 110 (e.g., Media Orientated Systems Transport (MOST), INICnet, or Automotive Audi Bus (A2B)) in a digital format. Similarly, it is possible to monitor or measure the time in which amplifier 104 outputs the desired action as indicated in the command at the measurement point 115 via the oscilloscope 156 that is in an analog format. Based on the measurement performed at measurement points 113 and 115, the system 100 may determine the total amount of time that the amplifier 104 executes the desired command to determine if the amount of time corresponds to OEM based requirement(s).

FIGURE 2 generally illustrates a more detailed implementation with test equipment 150 for measuring a delay of the amplifier 104 of the audio system of FIGURE 1. As shown, FIGURE 2 includes the audio controller 102, the amplifier 104, the loudspeakers 106, and test equipment 150. The implementation of the test equipment 150 may be used to determine the delay, d associated with the amplifier 104. The test equipment 150 includes a network analyzer 152, a network analyzer display 154, and an oscilloscope 156. The network analyzer 152 may be operably coupled to the control bus 110. It is recognized that the digital communication bus 110 may enable communication via a Media Oriented Systems Transport (MOST) or Automotive Audio Bus ("A2B"). The network analyzer 152 is configured to monitor bus activity between the audio controller 102 and the amplifier 104 given that the audio controller 102 and the amplifier 104 communicated digitally. As noted above, the network analyzer 152 may be operably coupled to the measurement point 113 in the system 100. The display 154 displays the bus activity on the control bus 110 to a user.

The oscilloscope 156 may be electrically coupled to an output of the amplifier 104 (or to the measurement point 115) to monitor signal transmission and other aspects related to the transmission of the amplified audio output to the loudspeakers 106. As noted, the amplifier 104 transmits the amplified audio output signal in the analog domain. In this regard, the oscilloscope 156 may be triggered based on a change of the output of the amplifier 104. Given that two different measurement sources are being used (e.g., the network analyzer 152 and the oscilloscope 156), it may be difficult to measure the delay, or the amount of time required for the amplifier 104 to process the control signal. Other reasons for the difficulty in measuring the delay involve, among other things, (i) the two devices (e.g., the network analyzer 152 and the oscilloscope 156) being made by different manufacturers or belonging to different tool vendors, (ii) challenges in synching time stamps on the digitized audio input signal with the output of the analog based audio output signal, (iii) zoom range, and/or (iv) a hard to set trigger for the oscilloscope 156 to the measure the output provided by the amplifier 104. In particular, the use of the oscilloscope 156 to measure the output of the amplifier 104 is different from the network analyzer 152 which is used to measure the control signal on the control bus 110 and thus there may not be an efficient method to sync the measured audio signal (or output of the amplifier 104) between the network analyzer 152 and the oscilloscope 156.

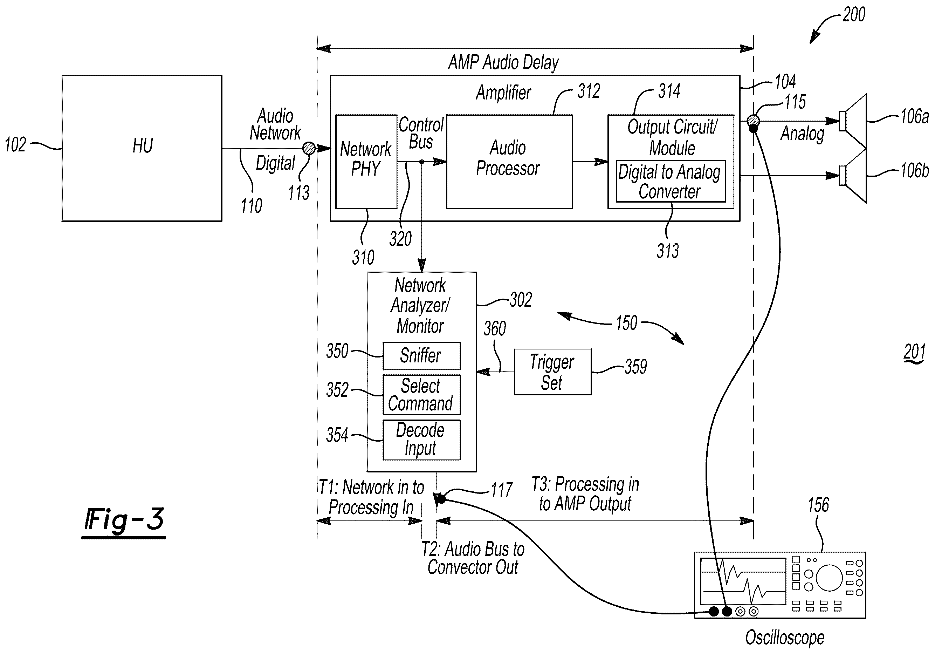

FIGURE 3 generally illustrates a system 200 for measuring an audio path delay for the audio system in accordance with one embodiment. The system 200 includes the audio controller 102, the amplifier 104, the plurality of loudspeakers 106, and the test equipment 150. Similar to FIGURE 1, the audio controller 102 transmits the control signal (or command) to the amplifier 104 via the control bus 110 in the digital domain. In addition, the amplifier 104 processes the received audio input signal and amplifies the same. The amplifier 104 then outputs the audio output signal in the analog domain. The test equipment 150 includes a network analyzer 302 and the oscilloscope 156. The network analyzer 302 (e.g., a first digital to analog converter) includes a sniffer circuit (or sniffer interface block) 350, a select command block 352, and a decode output block 354. The network analyzer 302 may be a digital to analog converter that is configured to convert digital data corresponding to information on the control signal into an analog signal.

In this regard, the test equipment 150 may be used to measure the delay in terms of the amount of time required for the amplifier 104 to process the control signal and for the amplifier 104 to perform the operation identified in the control signal. The system 200 also includes at least one measurement controller 201 (hereafter "the measurement controller 201") that may be operably coupled to the test equipment 150 for providing the delay or amount of time for the amplifier 104 to process the control signal and to perform the operation specified on the control signal. This will be discussed in more detail below. It is recognized that the measurement controller 201 may be part of the audio controller 102, the amplifier 104, and/or the test equipment 150.

The amplifier 104 includes a network physical layer 310, an audio processor 312, and an output circuit 314. The network physical layer 310 receives the audio input signal from the audio controller 102 and pre-processes data information on the audio input signal before such information is sent to the audio processor 312. The network physical layer 310 also receives the control signal from the audio controller 102 and pre-processes information on the control signal before such information is sent to the audio processor 312. The network physical layer 310 generally converts the control signal into a digital synchronous clock-based signal. In one example, the network physical layer 310 receives and decodes the control signal and provides a network management and control signal. The network physical layer 310 receives the control signal and the audio input signal and transfers the same between an internal portion of the audio controller 102 and a digital audio network. The network physical layer 310 transfers audio data on the audio input signal to control bus (or audio bus) 320 where the audio bus 320 is primarily internal to an electronic control unit (not shown) in the amplifier 104. It is recognized that the control bus 320 may be referred to herein as the audio bus and vice versa. In the network physical layer 310 transfers data indicative of a command on the control signal to network analyzer 302. The audio input signal once processed by the network physical layer 310 may include a bit clock and Frame Sync along with digital data corresponding to the desired audio data to be played back. The audio bus 320 may facilitate communication in accordance with the following protocols: I²S, time division multiplexing (TDM), etc. The audio bus 320 may also facilitate communication with respect to the control signal in accordance with the following protocols I²S, time division multiplexing (TDM), etc.

The audio processor 312 may perform any number of audio processing operations, such as, but not limited to, providing surround sound audio, providing immersive sound, muting, equalization, etc. In other words, the audio processor 312 may perform any one or more of the above noted operations based on the command(s) identified on the control signal. The type of audio processing operations performed by the audio processor 312 may vary based on different customer requirements. The network analyzer 302 is coupled to the audio bus 320. In general, the network analyzer 302 operates as digital to analog converter and converts digital data as transmitted on the audio bus 320 between the network physical layer 310 and the audio processor 312 into an analog domain. The output circuit 314 includes a digital to analog converter 313 (or a second digital to analog converter) for converting the digital data prior to the audio output signal being output to the loudspeakers 106. The oscilloscope 156 may be connected to an output of the network analyzer 302 (e.g., at a measurement point 117) of the network analyzer 302302 and to an output of the amplifier 104 (e.g., at the measurement point 115). The oscilloscope 156 obtains measurement(s) from the measurement points 115 and 117.

In general, the amount of time for the network physical layer 310 to process the control signal and to output the same on the audio bus 320 may be generally defined by a first time period (or first time delay), such as *T1.* The first time period, *T1* may be a known or fixed value (i.e., determined) as the manufacturer of the network physical layer 310 may provide information with respect to the amount of time that is consumed by the network physical layer 310 to process the control signal and to output the same on the audio bus 320. In yet other examples, the oscilloscope 156 may be used to measure the first time period, *T1* if such information pertaining to the known or fixed value is not available or inaccurately provided by the manufacturer. The measurement controller 201 may determine (or store) information corresponding to the first time period, *T1.*

The amount of time for the network analyzer 302 (e.g., digital to analog converter) to convert the digital data on the control signal from the audio bus 320 into an analog format may be fixed (or known) and is generally defined by a second time period (or second time delay) such as, *T2.* The information pertaining to the second time period, *T2* may also be known or fixed (i.e., determined) based on information provided by manufacturer of the r network analyzer 302. In yet other examples, the oscilloscope 156 may be used to measure the second time period, *T2* if such information pertaining to the known or fixed value is not available or inaccurately provided by the manufacturer. The measurement controller 201 may determine (or store) information corresponding to the second time period, *T2.* This aspect will be discussed in more detail below.

The amount of time required for the amplifier 104 (e.g., the output circuit 314) perform software processing and to amplify the audio input signal or perform any operation indicated on the control signal and provided by the output circuit 314 is generally defined by a third time period (or third time delay), such as, *T3.* In one example, the output circuit 314 includes any number of amplifiers (e.g., either software and/or hardware-based amplifiers) to amplify the audio output signal in the analog domain and to output the same to the loudspeakers 105. As noted above, the measurement controller 201 may store information corresponding to the first time period, *T1* and to the second time period, *T2* since these values may be previously known or fixed. The measurement controller 201 may also store information corresponding to the third time period, *T3* after the oscilloscope 156 measures this value and provides the same to the measurement controller 201. The measurement controller 201 sums the first-time delay *T1,* the second time delay *T2,* and the third time delay *T3* to provide a total time delay for the amplifier 104 to perform the desired operation as indicated on the control signal.

As noted above, the oscilloscope 156 may be coupled to an output of the network analyzer 302 (e.g., at the measurement point 117) to receive an analog version of the control signal and to an output of the amplifier 104 (e.g., at the measurement point 115) to receive the analog version of the audio output signal. Given that the output of the network analyzer 302 outputs an analog signal and the amplifier 104 outputs an analog signal, the oscilloscope 156 measures the two analog signal to determine the second time period, *T2* and the third time period, *T3.* As noted above, the first time period *T1* may be fixed and known and is stored in the measurement controller 201. The oscilloscope 156 may transmit the measurement or calculation of the second time period, *T2* and the third time period, *T3* to the controller 201. In turn, the measurement controller 201 may then sum the first time period, *T1;* the second time period, *T2;* and the third time period *T2* (e.g., T1 + T2 + T3) to ascertain the total amount of time (or delay) employed by the amplifier 104 to process the control signal, process the command indicated on the control signal,, and output the audio output signal to the loudspeakers 106. The measurement controller 201 may report out the delay attributed to the amplifier 104 to a user via a display (not shown) or other mechanism. It is recognized that various car manufacturers may employ strict requirements with respect to the overall delay employed by the amplifier 104 to receive the control signal, perform the operation indicated on the control signal, and to output the audio output signal to the loudspeakers 106. The disclosed system 200 enables audio providers the ability to accurately calculate such a delay.

The disclosed system 200 may generally measures the delay associated with the amplifier 104 in processing the control signal, performing the noted operation on the control signal, and outputting the audio output signal to the loudspeakers 106. The disclosed system 200 may also enable the user the ability to view network control signals (e.g., shift a fixed delay) and also view the output of the amplifier 104 in a same zoom. In general, the output of the network analyzer 302 and the amplifier 104 are both analog, thus it is possible for the oscilloscope 156 to measure the time delays associated with analog output of network analyzer 302 and the amplifier 104. In this case, the oscilloscope 156 has an input channel capability of > = 2. The disclosed system 200 may also execute a trigger for purpose of the oscilloscope 156 triggering the measurement for the outputs of the network analyzer 302 and of the amplifier 104. The oscilloscope 156 may receive an input from a user to set a certain signal level as a trigger to then start the time measurement of the outputs from the audio bus 320 to network analyzer 302 and the amplifier 304. Similarly, the disclosed system 200 may also extend the disclosed operations to perform a general cross signal measurement. In short, the with this extension, the delay measurement may be extended to a Digital Network A in, to a Digital Network B output, or Analog In and a Digital Network output.

As noted above, the network analyzer 302 includes the sniffer interface block 350, the select command block 352, a set trigger block 359 and the decode output block 354. The network analyzer 302 is generally configured to receive a trigger signal 360 from the set trigger block 359. The set trigger block 359 may include an interface that supports UART, SPI, etc. The set trigger block 359 is generally configured to output a command (or a trigger signal) 360 in response to a similar command being input into (or set by) the audio controller 102. Thus, audio controller 102 and the set trigger block 359 output the desired command to be executed or performed by the amplifier 104. In general, the audio controller 102 may transmit the command to the amplifier 104 and the network analyzer 302. In this case, the trigger block 359 may also provide the command on the signal 360 to the network analyzer 302. The network analyzer 302 is programmed to detect (or look for) the command as transmitted by the audio controller 102 to the amplifier 104 based on the command as received on the signal 360 and provided by the set trigger block 359.

The trigger signal 360 generally corresponds to a particular operation (or command that indicates the operation) that the amplifier 104 is to perform. In this regard, the measurement controller 201 may determine the delay (e.g., *T1, T2,* and *T3)* for the amplifier 104 to (i) process the control signal at the network physical layer 310 (e.g., *T1*), (ii) convert the processed control signal into a first processed control signal (e.g., *T2),* and (iv) output the desired audio output signal based on the desired operation to be performed by amplifier 104 *(e.g., T3)* as identified on the trigger signal 360. The trigger signal 360 may correspond to any number of operations that are performed by the amplifier 104 and generally correspond to the control signal that is provided by the head unit 102. Such operations may correspond to (i) a muting or unmuting operation, (ii) generating the audio output signal, and (iii) outputting an audio output signal at a special sound sequency, (iv) stopping or ceasing to transmit or output the audio output signal, etc. The trigger signal 360 generally serves as a trigger for the network analyzer 302 to monitor the command indicated on the control signal as output by the network physical layer 310 and for the oscilloscope 156 to initiate capturing an output (i.e., corresponding to the control signal) provided by the network analyzer 302. Thus, the delay T2 generally corresponds to an amount of time for the network physical layer 310 to output the control signal and the amount of time for the network analyzer 302 to output an analog signal. The analog signal serves as a trigger for the oscilloscope 156 to capture the delay, T2. Given the foregoing, it is possible for the measurement controller 201 to determine the total delay for a particular operation to be performed by the amplifier 104 by also taking into account the delays *T1, T2,* and *T3.* Therefore, it is possible for the system 200 to report out on the delays based on any number of operations performed by the amplifier 104 to demonstrate that the amplifier 104 meets customer's requirements.

The sniffer interface block 350 generally serves to receive the control signal over the audio bus 320. The sniffer interface block 350 provides an audio network physical layer (PHY) to support (i.e., receive) the control signal provided on the audio bus 320 such as an Inter-Integrated Circuit (I²C) interface, a spherical peripheral interface (SPI), a generalpurpose input/output (GIPO), Inter-IC Sound (I2C), a time division multiplexing ("TDM"), etc. One or more of the foregoing noted busses may be operational with the network physical layer 310. In response to the network analyzer 302 receiving the trigger signal 360, the sniffer interface block 350 starts to monitor for the control signal as provided on the audio bus 320.

The select command block 352 includes an OEM based-spec defined communication protocol analyzer logic and a trigger setting receiving logic to receive the trigger signal 360 which indicates the desired operation to be performed by the amplifier 104. The select command block 352 also interfaces with the sniffer interface block 350 to monitor for the control signal provided by the sniffer interface block 350. In this regard, the select command block 352 may also include an interface to communicate with the sniffer interface block 350 via I²C, SPI, GPIO, etc. The select command block 352 may receive the trigger signal 360 and the control signal (as output by the sniffer interface block 350). As noted above, the select command block 352 includes (or executes) the OEM spec defined communication protocol analyzer logic therein and has knowledge of what command(s) may be transmitted by audio controller 102. The select command block 352 also includes the trigger setting receiving logic to correspond with the set trigger block 359. In this case, in response to receiving the command on the signal 360 from the set trigger block 359, the select command block 352 is notified as to which command and parameter the is of interest and the network analyzer 302 can monitor for this command on the audio bus 302. Therefore, in response to the select command block 352 detecting a match between the command being transmitted on audio bus 320 and the command provided on the trigger signal 360, the select command block 352 may transmit a match signal to the decode output module 360. The decode output module 360 may transmit an output signal that indicates that the command has been detected. The output signal may be pulse or level signal (e.g., an edge-based signal where any rising or falling edge may be used) to trigger the oscilloscope 156 to perform a time measurement for the second time delay, *T2.*

Additionally or alternatively, the decode output block 354 may also include an interface to communicate with data (or the control signal) as transmitted via the audio bus 320 (e.g., I²C, SPI, GPIO, etc.) to monitor the control signal transmitted by the sniffer interface block 350 and the select command block 352. Similarly, the decode output block 354 may also receive information corresponding to the command indicated on the trigger signal 360. The decode output block 354 decodes information on the control signal and on the trigger signal 360 to determine if such information correspond to the same command. In the event the information on the control signal and on the trigger signal 360 correspond to the same information, the decode output block 354 outputs the pulse or level signal to trigger the oscilloscope 156 to capture the delay, *T2.* As noted above, the delay *T2* generally corresponds to an amount of time for the network physical layer 310 to output the control signal and the amount of time for the network analyzer 302 to output an analog signal.

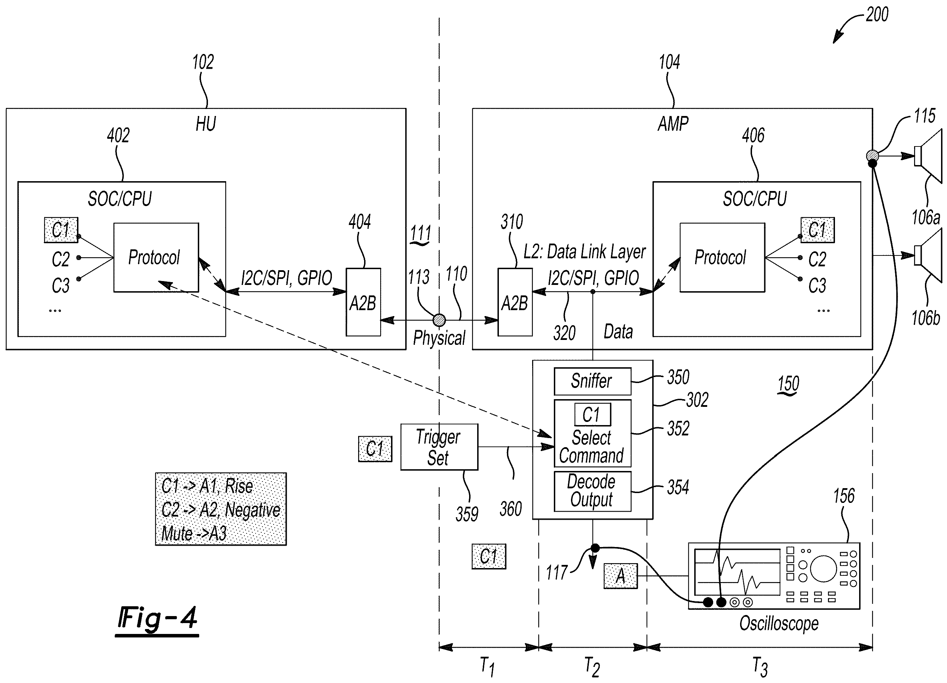

FIGURE 4 depicts a more detailed view of the system 200 in accordance with one embodiment. In general, the head unit 102 includes at least one first processor 402 and a network physical layer 404. The at least one processor 402 may be implemented as a central processing unit (CPU), a system of a chip (SoC), etc. The at least one processor 402 may transmit one or more control signals (or commands) (e.g., C1, C2, C3) to the network physical layer 404. The network physical layer 404 may be implemented as A2B physical layer to support bi-directional communication with the amplifier 104 and to transmit the one or more control signals (or commands) to the physical layer 310 (or the A2B physical layer) of the amplifier 104.

The amplifier 104 includes at least one second processor 406. The at least one second processor 406 may be implemented also as a central processing unit (CPU), a system of a chip (SoC), etc. The A2B physical layer 404 may transmit the one or more control signals (or commands) to the at least one second processor 406. The at least one second processor 406 is programmed to execute or perform the operation as identified on one or more of the control signals or commands (e.g., C1, C2, C3).

As noted above, the network analyzer 302 is coupled to audio bus 320 of the amplifier 320. The network analyzer 302 is configured to provide an output to enable the oscilloscope 156 to detect the delay *T2.* The delay T2 generally corresponds to an amount of time for the network physical layer 310 to output the control signal and the amount of time for the network analyzer 302 to output an analog signal. The set trigger block 359 generally provides a similar control signal (or command) as that provided by the head unit 102 to the amplifier 104. In this case, the network analyzer 302 monitors for information that corresponds to the control signal on the audio bus 320 within the amplifier 104. Upon detecting the information that corresponds to the control signal on the audio bus 320, the network analyzer 302 outputs an edge-based signal (e.g., either a rising edge or falling edge) at the measurement point 117. The oscilloscope 156 detects the change in the signal (e.g., rising or falling edge) to trigger the oscilloscope 156 to obtain a measurement that corresponds to the delay time, *T2.* In the example shown in FIGURE 4, the signal output by the network analyzer 302 has a rising edge. In general, "DATA" as shown in FIGURE 4 in connection with the audio bus 320 generally corresponds to raw data associated with the control signal (or command) that is transferred over the audio bus 320. Such raw data may be sniffed or retrieved by the sniffer interface block 302 which is then passed to the select command block 352 for further analysis.

It is recognized that the controllers as disclosed herein may include various microprocessors, integrated circuits, memory devices (e.g., FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, such controllers as disclosed utilizes one or more microprocessors to execute a computer-program that is embodied in a non-transitory computer readable medium that is programmed to perform any number of the functions as disclosed. Further, the controller(s) as provided herein includes a housing and the various number of microprocessors, integrated circuits, and memory devices ((e.g., FLASH, random access memory (RAM), read only memory (ROM), electrically programmable read only memory (EPROM), electrically erasable programmable read only memory (EEPROM)) positioned within the housing. The controller(s) as disclosed also include hardware-based inputs and outputs for receiving and transmitting data, respectively from and to other hardware-based devices as discussed herein.

While exemplary embodiments are described above, it is not intended that these embodiments describe all possible forms of the invention. Rather, the words used in the specification are words of description rather than limitation, and it is understood that various changes may be made without departing from the spirit and scope of the invention. Additionally, the features of various implementing embodiments may be combined to form further embodiments of the invention.

## Claims

1. An audio system comprising:
an audio controller programmed to transmit a control signal and an audio input signal;
an amplifier including at least one processor, the amplifier being programmed to:
process the control signal;
transmit the processed control signal on a control bus; and
execute the processed control signal at the at least one processor to perform an operation on the audio input signal; and
a measurement controller programmed to determine a total time delay for performing the operation on the audio input signal at the amplifier, wherein the total time delay corresponds to (i) a first time delay associated with at least processing the control signal; (ii) a second time delay associated with at least transmitting the processed control signal; and (iii) a third time delay associated with at least executing the processed control signal at the least one processor.

2. The audio system of claim 1, wherein the amplifier includes a first network physical layer to process the control signal prior to executing the processed control signal at the at least one processor.

3. The audio system of claim 2, wherein the first time delay is further associated with processing the control signal at the first network physical layer.

4. The audio system of claim 2 or 3, wherein the amplifier further includes a control bus positioned between the first network physical layer and the at least one processor.

5. The audio system of claim 4, wherein the second time delay is further associated with transmitting the processed control signal on the control bus.

6. The audio system of any preceding claim, further including a network analyzer programmed to provide a first output signal to trigger an oscilloscope to measure the second time delay.

7. The audio system of any preceding claim, wherein the control signal corresponds to one of (i) a command for the amplifier to mute or unmute an audio input signal, (ii) a command for the amplifier to output an audio output signal, and (iii) a command for the amplifier to output the audio output signal at a sound sequency.

8. A method for measuring a delay in an audio system, the method comprising:
receiving, at an amplifier, a control signal and an audio input signal;
processing, at the amplifier, the control signal;
transmitting the processed control signal on a control bus;
executing the processed control signal at a processor of the amplifier to perform an operation on the audio input signal; and
determining a total time delay for performing the operation on the audio input signal at the amplifier, wherein the total time delay corresponds to (i) a first time delay associated with at least processing the control signal; (ii) a second time delay associated with at least transmitting the processed control signal; and (iii) a third time delay associated with at least executing the processed control signal at the processor.

9. The method of claim 8 further including processing the control signal at a first network physical layer prior to executing the processed control signal at the at least one processor.

10. The method of claim 9, wherein the first time delay is further associated with processing the control signal at the first network physical layer.

11. The method of claim 9 or 10 further comprising positioning a control bus positioned between the first network physical layer and the processor.

12. The method of claim 11, wherein the second delay is further associated with transmitting the processed control signal on the control bus.

13. The method of any of claims 8 to 12, further comprising providing a first output signal to trigger an oscilloscope to measure the second time delay.

14. The method of any of claims 8 to 13, wherein the control signal corresponds to one of (i) a command for the amplifier to mute or unmute an audio input signal, (ii) a command for the amplifier to output an audio output signal, and (iii) a command for the amplifier to output the audio output signal at a sound sequency.

15. A computer-program product embodied in a non-transitory computer readable medium stored in memory that is programmed and executable by at least one controller in an audio system, the computer-program product comprising instructions that, when executed by the controller, cause the controller to perform the method of any of claims 8 to 14.
